# EUROPEAN PATENT APPLICATION

(11) **EP 1 641 134 A2**
(43) Date of publication of application: **29.03.2006**
(21) Application number: 05255618.0
(22) Date of filing: 14.09.2005
(51) Int. Cl.: H04B 1/20, H03J 1/00

(54) **Integrated remote control device and method for controlling multiple devices**

(30) Priority: 24.09.2004 KR 2004077185
(71) Applicant: Samsung Electronics Co., Ltd., Suwon-si, Gyeonggi-Do (KR)
(72) Inventor: Chang, Woo-yong, 102-503 Samsung Myeongga Town, Yonsin-si Gyeonggi-do (KR)
(74) Representative: Robinson, Ian Michael

(57) **Abstract**

An integrated remote control device and method for controlling multiple devices are provided. The integrated remote control device includes an input unit (310) into which device selection information and a control command are input by a user, a mapping information database (DB) (330) which stores a key code of a control target device or stores button-device mapping information if key codes of two or more control target devices correspond to a function button, a control unit (320) which extracts the key code from the mapping information DB (330), or extracts button-device mapping information from the mapping information DB (330) and allocates a key code corresponding to the function button according to extracted button-device mapping information, a memory (340) which receives the key code and button-device mapping information from the mapping information DB (330) and provides the key code corresponding to the function button, and an output unit (360) which outputs the key codes provided from the memory (340).

## Description

The present invention relates to a remote control device and method for controlling two or more target devices.

With the spread of home theater systems and the emergence of various media, not only the number of home appliances, but the number of remote control devices controlling them, is increasing.

However, the use of different remote control devices for operating different appliances is troublesome and users have difficulty in searching for and using a remote control device suitable for each device and function when using an appliance such as a video appliance in which various devices are interconnected.

Thus, integrated remote control devices capable of controlling a plurality of appliances have been developed. Integrated remote control devices are disclosed in many patent documents.

For example, Korean Unexamined Patent Publication No. 1999-0048990 discloses an integrated remote control device and method. In this document, the integrated remote control device having a liquid crystal display (LCD) unit includes a plurality of appliance modes. Once a user selects one of the appliance modes, various function keys suitable for an appliance corresponding to the selected appliance mode are displayed in the form of a touch panel on the LCD unit of the integrated remote control device. In this way, a remote control function suitable for each appliance can be implemented.

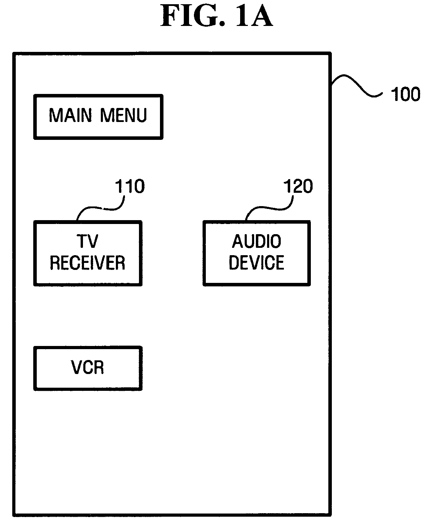

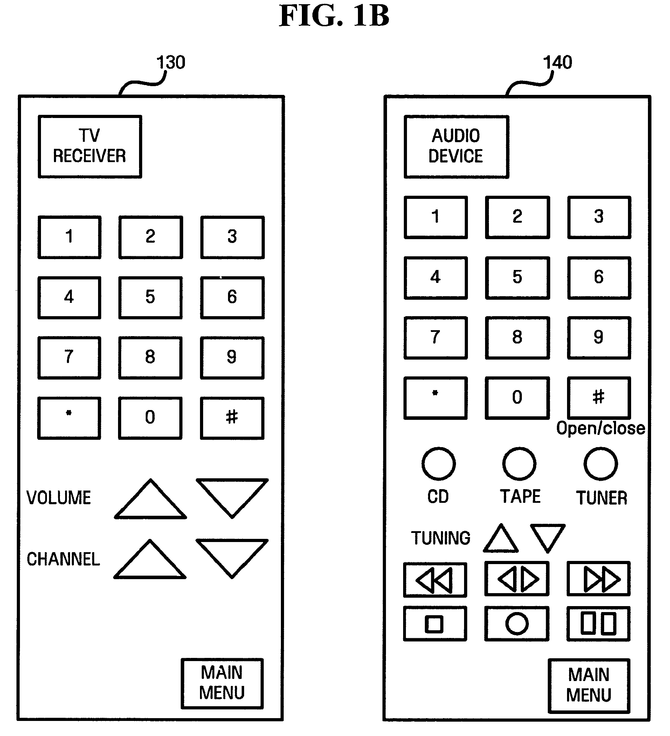

Figures 1A and 1B illustrate the integrated remote control device disclosed in Korean Unexamined Patent Publication No. 1999-0048990. Figure 1A illustrates a main menu that is displayed in the form of a touch panel on an LCD unit of an integrated remote control device 100. Once a user presses a television (TV) receiver button 110 or an audio device button 120, a function key menu screen 130 corresponding to a TV receiver or a function key menu screen 140 corresponding to an audio device is displayed in the form of a touch panel as shown in Figure 1B.

Although the integrated remote control device is a single entity, a separate mode is assigned to each control target device. As a result, a user should change a mode whenever using another device, causing the user to feel troubled and confused.

According to the present invention there is provided an apparatus and method as set forth in the appended claims. Preferred features of the invention will be apparent from the dependent claims, and the description which follows.

In one aspect of the present invention there is provided a convenient integrated remote control device and method, in which two or more control target devices are controlled simultaneously using a single remote control device without changing modes, thereby removing a user's confusion about control target devices and the inconvenience of changing modes for each control target device.

The present invention provides ease of use by making it possible to control a plurality of control target devices using a single remote control device.

The present invention also provides ease of use and reduction in user errors by making it possible to remotely control two or more control target devices in a single mode without changing modes.

According to an aspect of the present invention, there is provided an integrated remote control device including an input unit into which device selection information and a control command are input by a user, a mapping information database (DB) which stores a key code of a control target device or stores button-device mapping information if key codes of two or more control target devices correspond to a function button, a control unit which extracts the key code from the mapping information DB, or extracts the button-device mapping information from the mapping information DB and allocates a key code corresponding to the function button according to the extracted button-device mapping information; a memory which receives the key code and the button-device mapping information from the mapping information DB and provides the key code corresponding to the function button, and an output unit which outputs the key codes provided from the memory.

According to another aspect of the present invention, there is provided an integrated remote control method including a user selecting a control target device, extracting a key code of the selected control target device, extracting button-device mapping information of a combination of two or more control target devices if there exists another previously selected control target device, mapping a key code to a function button according to the button-device mapping information, the user inputting a control command, and outputting a mapped code signal responsive to the control command input by the user.

The above and other aspects of the present invention will become more apparent by describing in detail exemplary embodiments thereof with reference to the attached drawings in which:
Figures 1A and 1B illustrate a conventional integrated remote control device;
Figure 2 is a schematic view of an integrated remote control device according to an exemplary embodiment of the present invention;
Figure 3 is a block diagram of an integrated remote control device according an exemplary embodiment of the present invention;
Figure 4 is a flowchart illustrating an integrated remote control method according to an exemplary embodiment of the present invention;
Figure 5 is a flowchart illustrating an integrated remote control method according to another exemplary embodiment of the present invention;
Figure 6 illustrates an algorithm for mapping control target devices to function buttons of an integrated remote control device according to another exemplary embodiment of the present invention;
Figure 7 illustrates an exemplary embodiment in which the algorithm of Figure 6 is applied; and
Figure 8 is a view for explaining an operation of an integrated remote control device according an exemplary embodiment of the present invention.

Advantages and features of the present invention and methods of accomplishing the same may be understood more readily by reference to the following detailed description of exemplary embodiments and the accompanying drawings. The present invention may, however, be embodied in many different forms and should not be construed as being limited to the embodiments set forth herein. Rather, these embodiments are provided so that this disclosure will be thorough and complete and will fully convey the concept of the invention to those skilled in the art, and the present invention will only be defined by the appended claims. Like reference numerals refer to like elements throughout the specification.

Exemplary embodiments of the present invention will now be described in detail with reference to the accompanying drawings.

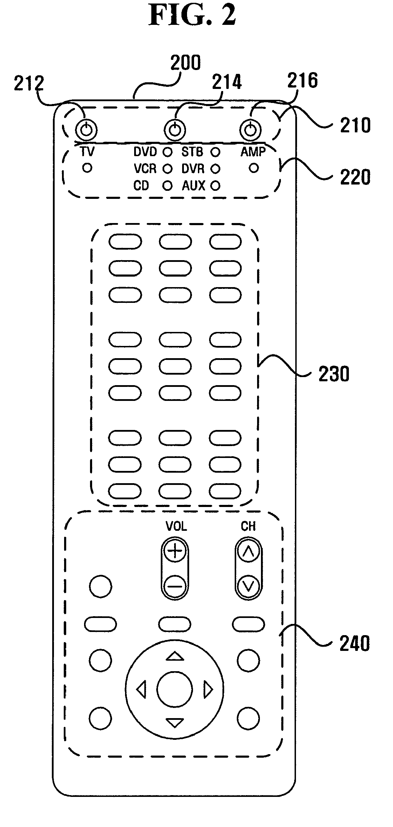

Figure 2 is a schematic view of an integrated remote control device 200 according to an embodiment of the present invention.

The integrated remote control device 200 according to an exemplary embodiment of the present invention includes a device selection button unit 220 for selecting a control target device, a power button unit 210 for a selected control target device, a unique function button unit 230 for a selected control target device, and a common function button unit 240 for implementing common functions of multiple control target devices.

A user can select a control target device by pressing a device selection button corresponding to the control target device through the device selection button unit 220. If a single control target device is selected, the integrated remote control device 200 functions as a remote control device of the selected control target device in a single mode like a conventional integrated remote control device. If two or more control target devices are selected, the integrated remote control device 200 functions as a remote control device capable of simultaneously controlling the selected plurality of control target devices in a multi-mode.

Various methods can be implemented to select and release a multi-mode. First, a toggling method using a toggle button may be employed to select a corresponding device. That is, upon pressing of the toggle button, the corresponding device is selected, and the selection of the corresponding device is released upon re-pressing of the pressed toggle button. In this case, if two or more devices are selected, the toggling method may also implement a multi-mode. Second, multi-mode selection may be achieved by pressing a device selection button corresponding to a second desired control target device for a long time and may be released by pressing a device selection button corresponding to a desired control target device for a short time, so that only the control target device corresponding to the pressed device selection button is selected and the selection of the remaining previously selected devices is released.

The button unit 220 not only allows selection of a control target device but also serves as an indicator that shows a selection state of a corresponding control target device by turning on a lamp, or another type of indicator as would be understood in the art, corresponding to a selected control target device. In this embodiment, control target devices may include a TV, a source device, and/or an amplifier (AMP). A source device may be a digital versatile disc (DVD), a set-top box (STB), a video cassette recorder (VCR), a digital video recorder (DVR), a compact disc (CD), an auxiliary device (AUX), or another source device as would be understood in the art. Only a single source device is selected at a time in this embodiment, but two or more source devices may be selected at a time in another embodiment. Hereinafter, the TV may be a general TV or any device having a display device as would be understood in the art; the AMP may be an AMP that outputs audio, an AMP according to the home theater standard (HTS), or a device having an AMP; and the source device may be a device that outputs video or audio data to other devices. A composite device having multiple functions such as a home theater system can be included in all the three categories of the TV, the AMP, and the source device. Therefore, a composite device such as a home theater system that may be included in two or more categories may be classified in the order of a TV, then an AMP, then a source device. In other words, a home theater system is classified as a TV and a DVD having an AMP is classified as an AMP.

The power button unit 210 for a selected control target device can operate independently of the device selection button unit 220 as in this embodiment or can interoperate with the device selection button unit 220. In other words, the selection of a control target device and the turning on/off of a selected control target device can be performed separately from each other or a control target device can be turned on upon the selection of the control target device and turned off upon the release of the selection. In this embodiment, the TV or the AMP may be turned on by pressing a power button 212 or 216 of the power button unit 210 even without being selected.

The unique function button unit 230 and the common function button unit 240, which are realized as an LCD, an inorganic electro-luminescence (EL) display, an organic EL display, an E-Ink display, or another display as would be understood in the art, include function buttons of the integrated remote control device 200 whose functions vary in accordance with the combination of selected control target devices, and can implement a functional change according to multi-mode selection. The unique function button unit 230 may display only those buttons required for control of a selected control target device. If two or more control target devices correspond to the same unique function button, a key code of function of the control target device selected by button-device mapping information among the two or more control target devices is mapped to the unique function button unit 230.

Unique function buttons of the unique function button unit 230 are displayed differently according to the control target device they are associated with. For example, the unique function buttons of the unique function button unit 230 have different colors, shapes or positions for different control target devices to allow a user to intuitively recognize which button controls which device. In the event that the unique function button unit 230 is implemented with hardware buttons instead of an LCD display, an organic EL display, an inorganic EL display, an E-Ink display or the like, convenience of use can be provided by using different color backlights or other indicators for unique function buttons corresponding to different control target devices. Such implementation may also be applied to the common function button unit 240.

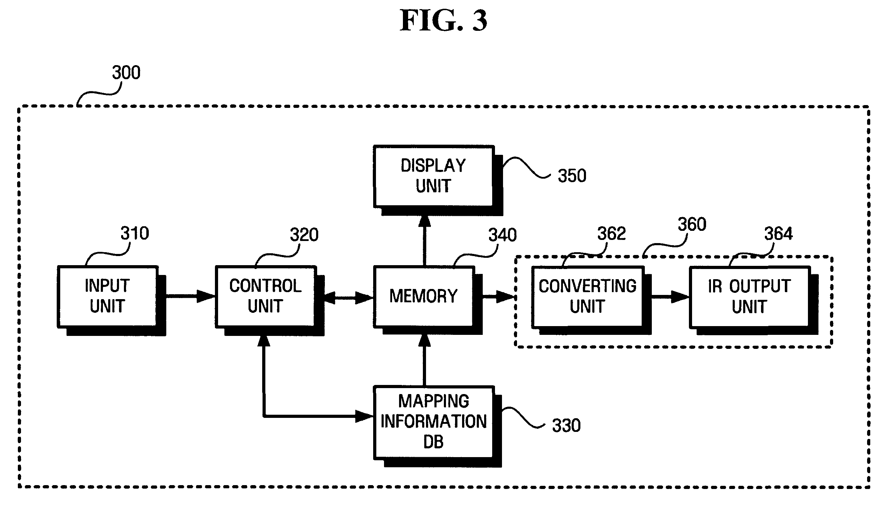

The common function button unit 240 includes common function buttons for implementing common functions of a plurality of control target devices such as volume or channel adjustment. In a multi-mode where two or more control target devices are selected, a key code of a function used by multiple control target devices is assigned to the common function button unit 240 according to button-device mapping information for each button. The button-device mapping information depends upon a particular combination of control target devices, which will be described later with reference to Figure 3.

If the common function button unit 240 is implemented with an LCD, it can display information of a control target device to which a common function button of the common function button unit 240 is mapped. For example, if a channel button is mapped to the TV, "TV" may be displayed on the channel button, so that a user can recognize which common function button is assigned to which control target device. Such implementation may also be applied to the unique function button unit 230.

Figure 3 is a block diagram of an integrated remote control device 300 according an embodiment of the present invention.

Since a user may own various devices, codes of devices to be used and a code of an integrated remote control device need to be previously synchronized to operate the devices. Suppliers of integrated remote control devices may provide a codebook that stores codes of various devices for a user's reference in code synchronization.

The integrated remote control device 300 according to an exemplary embodiment of the present invention includes an input unit 310, a control unit 320, a mapping information database (DB) 330, a memory 340, a display unit 350, and an output unit 360 having a converting unit 362 and an infrared (IR) output unit 364. These components of the integrated remote control device 300 may be implemented with software and/or hardware.

Device selection information is input through the button unit 220 and a control command for a control target device is input through the unique function button unit 230 and the common function button unit 240 to the input unit 310 by a user.

The mapping information DB 330 stores key codes of a control target device, and stores button-device mapping information if key codes of two or more control target devices correspond to the unique function button unit 230 and the common function button unit 240 in a multi-mode. The key codes are code values for controlling a control target device and the mapping information DB 330 stores key codes of control target devices that can be supported by the integrated remote control device 300.

The button-device mapping information is information about the relative priorities of control target devices to which each function button can be mapped according to a particular combination of selected control target devices in a multi-mode where two or more control target devices are selected. If a control target device is classified as a TV, a source device, or an AMP, the relative priorities of control target devices to which each function button can be mapped are as follows according to an exemplary embodiment of the present invention.
1. Source button: TV > Source device (if a source device has an external input function)
2. Volume button: AMP > TV > Source device (if a source device has a volume controller)
3. Channel button: Source device (if a source device has a channel controller) > TV > AMP
4. Menu, Info, Return, Exit, and five direction key buttons: Source device > TV > AMP (if an AMP has an on screen display (OSD))
5. Guide button: Source device (if a source device is of a type of an STB) > TV (if a TV has a guide function)
6. Tool button: Source device > TV > AMP
7. Sound button: AMP > TV> Source device (if a TV or a source device has a sound field control function)
8. Navigation function button such as Forward/reverse search, Rewind, Fast forward, Play, Stop, Pause, and Record: Source device
9. Number pad: Source device > TV > AMP

The priorities are inferred by modeling a user's wishes by a particular combination of selected control target devices when the same function button is used for various control target devices. The priorities can be experimentally obtained by analyzing user's attitude and purpose in use. Thus, the above priorities are only an example of the button-device mapping information.

Hereinafter, a description will be made regarding an example of mapping of key codes to function buttons according to the priorities in a multi-mode. If a user selects a TV, a DVD (source device), and an AMP as control target devices, the TV is mapped to a source button, a key code corresponding to a volume function of the AMP is mapped to a volume button, a key code corresponding to a channel function of the TV is mapped to a channel button, and a key code corresponding to a menu function of the DVD is mapped to a menu button.

An embodiment of the button-device mapping in a multi-mode according to the priorities is shown in Table 1.

**Table 1**

| | TV + VCR | TV +VCR +AMP | TV + DVD | TV +DVD +AMP | TV +STB | TV +STB +AMP | TV +AMP (HTS) | CD +AMP |
|---|---|---|---|---|---|---|---|---|
| Volume | TV | AMP | TV | AMP | TV | AMP | AMP | AMP |
| Mute | TV | AMP | TV | AMP | TV | AMP | AMP | AMP |
| Source | TV | TV | TV | TV | TV | TV | TV | X |
| Channel | VCR | VCR | TV | TV | STB | STB | TV | X |
| Menu | VCR | VCR | DVD | DVD | STB | STB | AMP | CD |
| Tool | VCR | VCR | DVD | DVD | STB | STB | TV | CD |
| Return | VCR | VCR | DVD | DVD | STB | STB | AMP | CD |
| Information | VCR | VCR | DVD | DVD | STB | STB | AMP | CD |
| Exit | VCR | VCR | DVD | DVD | STB | STB | AMP | CD |
| Five key direction key | VCR | VCR | DVD | DVD | STB | STB | AMP | CD |
| Navigation | VCR | VCR | DVD | DVD | X | X | X | CD |
| Sound | TV | AMP | TV | AMP | TV | AMP | AMP | AMP |
| Guide | TV | TV | TV | TV | STB | STB | TV | x |

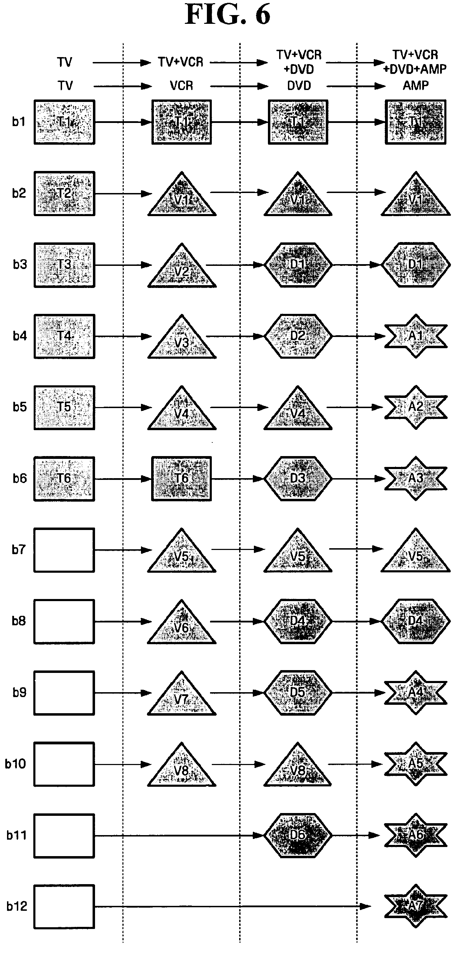

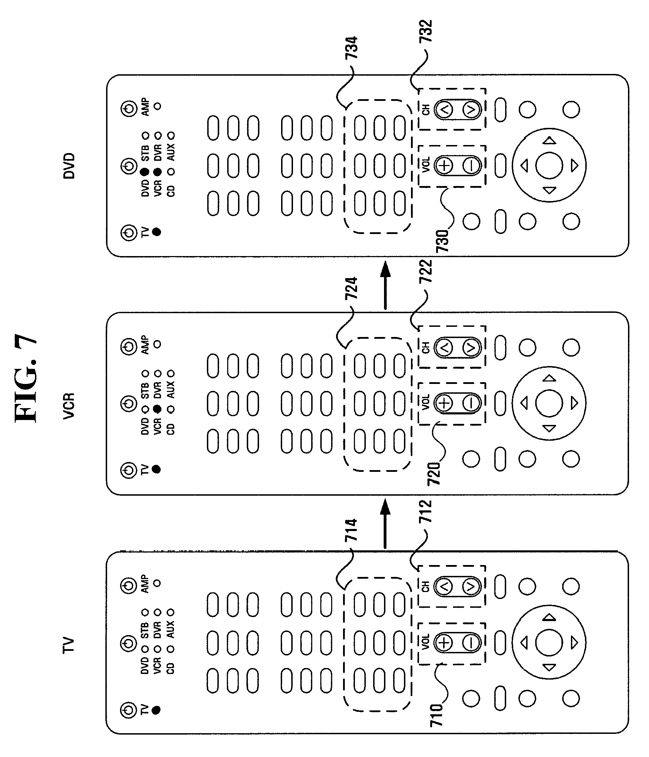

In another embodiment, the priorities of control target devices to which each function button can be mapped may be determined depending on the order in which two or more control target devices are selected. Such an exemplary embodiment will be described with reference to Figures 6 and 7 later.

The control unit 320 extracts a key code of a corresponding device from the mapping information DB 330 according to device selection information provided from the input unit 310, extracts button-device mapping information of the integrated remote control device 300 from the mapping information DB 330 in a multi-mode, and assigns a key code to a function button according to the extracted button-device mapping information.

The memory 340 stores the key code and the button-device mapping information, extracted and output from the mapping information DB 330 by the control unit 320, and outputs a portion to be displayed in the unique function button unit 230 according to the key code and the button-device mapping information to the display unit 350.

The output unit 360 outputs the key code provided from the memory 340 and includes the converting unit 362 that converts the key code into a signal that is suitable for output and the IR output unit 364 that outputs an IR ray according to the signal converted by the converting unit 362.

The display unit 350 displays buttons required for control of a selected control target device in the unique function button unit 230 and may be implemented with an LCD, an inorganic EL display, an organic EL display, an E-Ink display, or another display device as would be understood in the art.

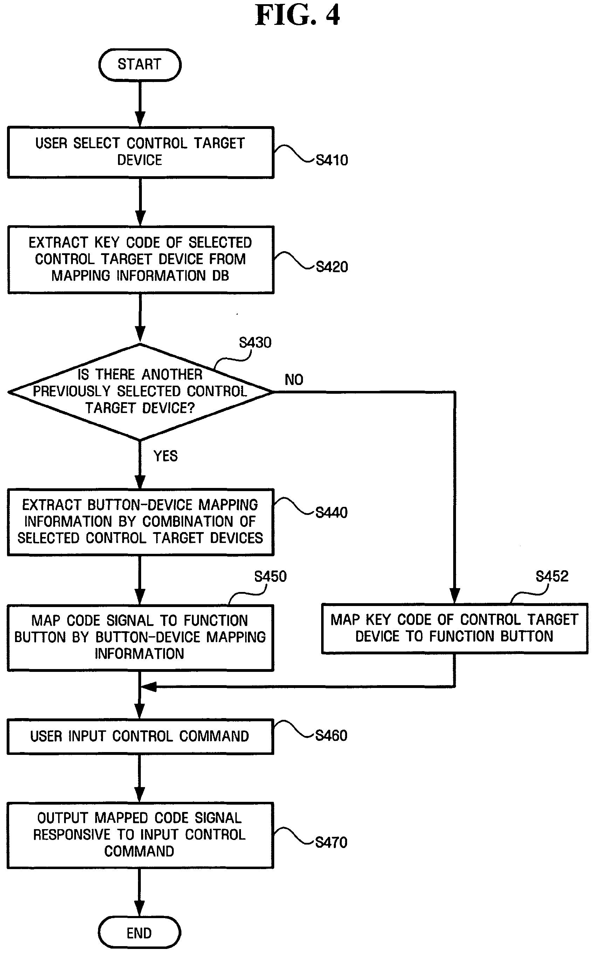

Figure 4 is a flowchart illustrating an integrated remote control method according to an exemplary embodiment of the present invention.

Once a user selects a control target device through the device selection button unit 220 in operation S410, the control unit 320 receives device selection information from the input unit 310 and extracts a key code corresponding to a selected device from the mapping information DB 330 in operation S420. If another control target device is already selected in operation S430, a multi-mode operates. Thus, the control unit 320 extracts button-device mapping information from the mapping information DB 330 of an integrated remote control device in operation S440 and outputs the extracted button-device mapping information to the memory 340, the button-device mapping information determined by a particular combination of the selected control target devices. The control unit 320 maps key codes of selected control target devices extracted in operation S420 to function buttons of the integrated remote control device according to the extracted mapping information in operation S450. Once a control command is input by the user through the unique function button unit 230 and the common function button unit 240 in operation S460, a mapped code signal corresponding to the control command is output through the output unit 360 in operation S470.

If only a single control target device is selected, a key code of the control target device, extracted in operation S420, is mapped to a function button of the integrated remote control device in operation S452. Once a control command is input by the user through the unique function button unit 230 and the common function button unit 240 in operation S460, a mapped code signal corresponding to the control command is output through the output unit 360 in operation S470.

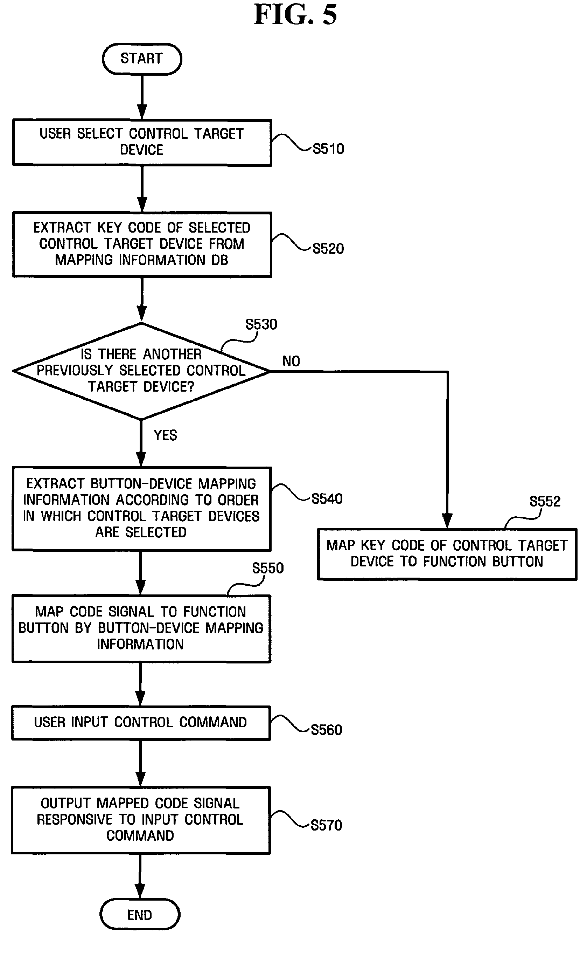

Figure 5 is a flowchart illustrating an integrated remote control method according to another exemplary embodiment of the present invention.

Operations shown in Figure 5 are the same as those shown in Figure 4 except for operation S540. This embodiment is different from that shown in Figure 5 in that button-device mapping information is determined by a combination of already selected control target devices while giving the highest priority to a last selected control target device. In other words, the button-device mapping information is determined depending on the order that the control target devices are selected in this embodiment. Description about the button-device mapping information according to the order in which the control target devices are selected will be described with reference to Figures 6 and 7.

Figure 6 illustrates an algorithm for mapping a control target device to a function button of an integrated remote control device according to another exemplary embodiment of the present invention.

In Figure 6, functions of control target devices are mapped to the unique function button unit 230 and the common function button unit 240 in a multi-mode with reference to not only the particular combination of the control target devices but also the order in which the control target devices are selected. Referring to Figure 6, once a user selects a TV and performs a remote control, buttons b1 through b6 are used. Thereafter, once the user selects a VCR as a source device, the integrated remote control device recognizes a multi-mode in which the TV and the VCR are simultaneously controlled and assigns buttons V1 through V4 among buttons used by the TV and new buttons V5 through V8 to the VCR. Thereafter, once the user selects a DVD as another source device, the integrated remote control device recognizes a multi-mode in which the TV, the VCR, and the DVD are simultaneously controlled. Since the DVD is last selected, the DVD has priority over the VCR as a source device. Once the user additionally selects the AMP, the integrated remote control device recognizes a multi-mode in which the TV, the VCR, the DVD, and the AMP are simultaneously controlled and assigns buttons A1 through A6 that are already assigned to the DVD and the VCR and a new button A7 to the AMP.

Figure 7 illustrates an exemplary embodiment in which the algorithm of Figure 6 is applied.

Once the user selects the TV, a volume button 710, a channel button 712, and a number panel 714 are mapped to the TV. Thereafter, if the user selects the VCR, the volume button 720 is mapped to the TV, but the channel button 722 and the number panel 724 are mapped to the VCR. Once the user selects the DVD in a TV+VCR multi-mode, the volume button 730 is mapped to the TV and the channel button 732 is mapped to the VCR, but the number panel 734 is mapped to the DVD. Although the VCR also requires a number panel function, the DVD is selected later than the VCR and thus has a priority over the VCR.

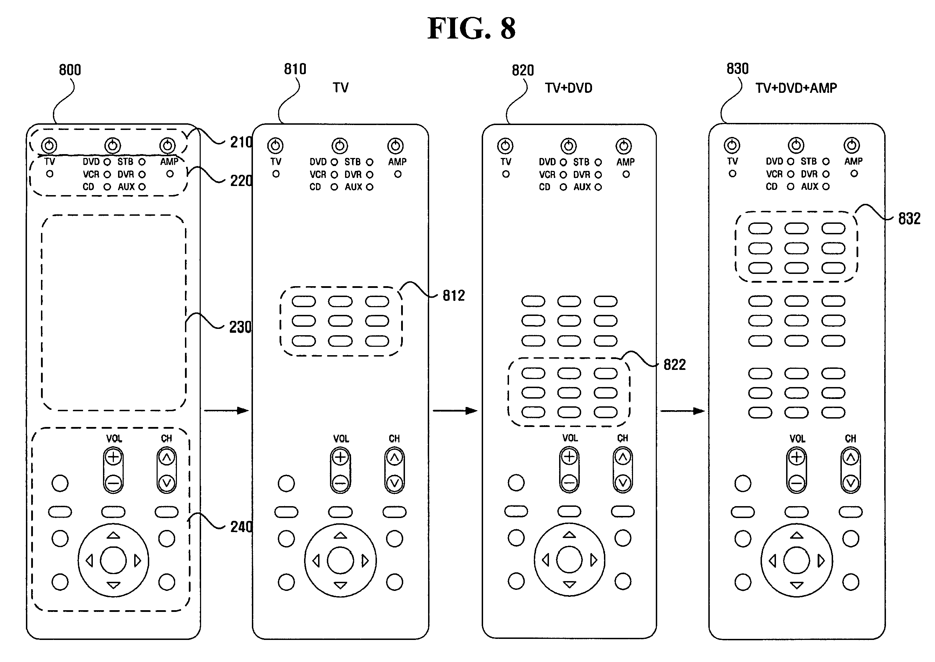

Figure 8 is a view for explaining an operation of an integrated remote control device according an exemplary embodiment of the present invention.

An integrated remote control device 800 according to an embodiment of the present invention includes the device selection button unit 220, the power button unit 210 for a selected control target device, the unique function button unit 230 for a selected control target device, and the common function button unit 240 for implementing common functions of various control target devices, as shown in Figure 2. If a user selects a TV (810), a unique function button unit 812 required for control of the TV is displayed and a key code of the TV is mapped to the common function button unit 240. If the user then selects a DVD while the TV is selected in a multi-mode (820), a unique function button unit 822 required for control of the DVD is displayed and key codes of the TV and the DVD are mapped to the common function button unit 240 according to button-device mapping information. Thus, the user can simultaneously and remotely control the TV and the DVD without changing modes. Once the user selects an AMP in a TV+DVD (830) multi-mode, a unique function button unit 832 required for control of the AMP is displayed and key codes of the TV, the DVD, and the AMP are mapped to the common function button 240 depending on the button-device mapping information. Thus, the user can control the TV, the DVD, and the AMP like a single device without changing modes.

An integrated remote control device of the present invention provides at least the following advantages.

First, convenience in use is provided to a user by controlling a plurality of control target devices with a single remote control device.

Second, a user error is reduced by remotely controlling two or more control target devices without changing modes.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. An integrated remote control device comprising:
a mapping information database (DB) (330) which stores a key code of a control target device or stores button-device mapping information if key codes of at least two control target devices correspond to a function button;
an input unit (310) into which at least one input control target device and a control command are input by a user, the input unit (310) comprising the function button;
a control unit (320) which extracts the key code of the at least one input control target device from the mapping information DB (330), and extracts the button-device mapping information from the mapping information DB (330) and allocates a key code corresponding to the function button according to the extracted button-device mapping information if there are at least two input control target devices input into the input unit (310);
a memory (340) which receives the key code and the button-device mapping information from the mapping information DB (330) and provides the key code corresponding to the function button; and
an output unit (360) which outputs the key codes provided from the memory (340).

2. The integrated remote control device of claim 1, wherein the button-device mapping information comprises information about priorities of the at least two control target devices to which the function button corresponds.

3. The integrated remote control device of claim 2, wherein:
each of the at least two control target devices corresponding to the function button comprises a television (TV), a source device, or an amplifier (AMP); and
the priorities are:
the TV and then the source device with respect to a source button,
the AMP, then the TV, then the source device with respect to a volume button,
the source device, then the TV, then the AMP with respect to a channel button,
the source device, then the TV, then the AMP with respect to a menu button, an info button, a return button, an exit button, and a 5-direction key button,
the source device and then the TV with respect to a guide button,
the source device, then the TV, then the AMP with respect to a tool button,
the AMP, then the TV, then the source device with respect to a sound button,
the source device with respect to a navigation function button, and
the source device, then the TV, then the AMP with respect to a number pad.

4. The integrated remote control device of claim 1, 2 or 3, wherein the button-device mapping information comprises information about priorities of the at least two control target devices to which the function button corresponds according to the order in which two or more input control target devices are input.

5. The integrated remote control device of claim 1, 2, 3 or 4, wherein the control unit (320) selects a unique function button for a control target device.

6. The integrated remote control device of claim 5, further comprising a display unit (350) which displays the selected unique function button.

7. The integrated remote control device of any preceding claim, wherein the output unit (360) comprises:
a converting unit (362) which converts a key code into a signal that is suitable for output; and
an infrared (IR) output unit (364) which outputs an IR ray according to the converted signal.

8. The integrated remote control device of any preceding claim, wherein the function button is implemented by at least one of a liquid crystal display (LCD), an inorganic electro-luminescence (EL) display, an organic EL display, and an E-ink display.

9. The integrated remote control device of any preceding claim, wherein the function button is displayed differently according to the selected control target device which is mapped to the function button.

10. An integrated remote control method comprising:
selecting a control target device;
extracting a key code of the selected control target device;
extracting button-device mapping information of at least two control target devices if there exists another previously selected control target device;
mapping a key code to a function button according to the button-device mapping information;
inputting a control command; and
outputting a mapped code signal responsive to the input control command.

11. The integrated remote control method of claim 10, wherein the button-device mapping information is information about the priorities of the at least two control target devices to which each function button is mapped by the at least two control target devices.

12. The integrated remote control method of claim 11, wherein:
each of the at least two control target devices comprises a television (TV), a source device, or an amplifier (AMP); and
the priorities are the TV and then the source device with respect to a source button,
the AMP, then the TV, then the source device with respect to a volume button,
the source device, then the TV, then the AMP with respect to a channel button,
the source device, then the TV, then the AMP with respect to a menu button, an info button, a return button, an exit button, and a 5-direction key button,
the source device and then the TV with respect to a guide button,
the source device, then the TV, then the AMP with respect to a tool button,
the AMP, then the TV, then the source device with respect to a sound button,
the source device with respect to a navigation function button, and
the source device, then the TV, then the AMP with respect to a number pad.

13. The integrated remote control method of claim 10, 11 or 12, wherein the button-device mapping information comprises information about the priorities of the at least two control target devices to which a function button can be mapped by the order that the at least two control target devices are selected.

14. The integrated remote control method of any of claims 10 to 13, further comprising displaying a unique function button for the selected control target device after the extraction of the key code.

15. The integrated remote control method of any of claims 10 to 14, wherein the outputting of the mapped code signal comprises:
converting the code signal into a signal that is suitable for output; and
outputting an IR ray according to the converted signal.

16. The integrated remote control method of any of claims 10 to 15, wherein the function button is implemented by at least one of a liquid crystal display (LCD), an inorganic electro-luminescence (EL) display, an organic EL display, and an E-ink display.

17. The integrated remote control method of any of claims 10 to 16, wherein the function button is displayed differently according to the selected control target device.

18. A recording medium having a computer readable program recorded therein, the program for executing an integrated remote control method comprising:
selecting a control target device;
extracting a key code of the selected control target device;
extracting button-device mapping information of at least two control target devices if there exists another previously selected control target device;
mapping a key code to a function button according to the button-device mapping information;
inputting a control command; and
outputting a mapped code signal responsive to the input control command.
